# EUROPÄISCHE PATENTSCHRIFT

(11) **EP 3 945 761 B1**
(45) Veröffentlichungstag und Bekanntmachung des Hinweises auf die Patenterteilung: **11.09.2024**
(21) Anmeldenummer: 20188597.7
(22) Anmeldetag: 30.07.2020
(51) Int. Cl.: H05K 7/20, H02B 1/56

(54) **LEITUNGSINSTALLATIONSGEHÄUSE MIT KÜHLUNG**
DUCT INSTALLATION HOUSING WITH COOLING
BOITIER D'INSTALLATION DE CONDUITES À REFROIDISSEMENT

(43) Veröffentlichungstag der Anmeldung: 02.02.2022
(73) Patentinhaber: Hauff-Technik GRIDCOM GmbH, 73494 Rosenberg (DE)
(72) Erfinder: Brüggemann, Christian, 32791 Lage (DE)
(74) Vertreter: König Szynka Tilmann von Renesse Patentanwälte Partnerschaft mbB München

(56) Entgegenhaltungen:
- EP-A1- 3 772 876
- DE-A1- 102008 022 000
- DE-B3- 102008 056 062
- DE-U1- 29 823 425

## Beschreibung

Die vorliegende Erfindung betrifft ein Leitungsinstallationsgehäuse für Signalleitungen, das mit einem Lüfter gekühlt werden kann.

Leitungsinstallationsgehäuse sind an sich bekannt, z. B. als sogenannte Verteilerschränke im Innenbereich (innerhalb von Gebäuden) und im Außenbereich. Es handelt sich um Gehäuse, in denen Leitungen, vorliegend Signalleitungen (insbesondere für die Telekommunikation) ein- und/oder auslaufen, miteinander gekoppelt sind, Signalverstärkungen durchlaufen, an Signalumsetzer gekoppelt sind (z. B. von elektrischen zu optischen Signalen und umgekehrt) oder Ähnliches.

Solche Gehäuse haben die Aufgabe, ihren Innenraum gegenüber mechanischen Beschädigungen und Verschmutzung zu schützen. In diesem Zusammenhang sind bereits Leitungsinstallationsgehäuse mit doppelt ausgeführten Gehäusewänden benutzt worden, insbesondere mit Seitenwänden, die zusätzlich zu einer Innenwand eine weitere Außenwand aufweisen.

DE102008022000 A1 offenbart ein schrankartiges Gehäuse zur Aufnahme von Wärme erzeugenden elektrischen/ elektronischen Baueinheiten.

Der vorliegenden Erfindung liegt die Aufgabe zugrunde, ein hinsichtlich seiner Funktionstüchtigkeit verbessertes Leitungsinstallationsgehäuse für Signalleitungen anzugeben.

Hierzu richtet sich die Erfindung auf ein Leitungsinstallationsgehäuse für Signalleitungen nach Anspruch 1.

Die Erfindung geht zunächst von der Überlegung aus, dass es jedenfalls bei bestimmten Aufstellungsorten und bestimmten Leitungsinstallationen zu einem Kühlbedarf des Innenraums kommen kann. Dies betrifft z. B. hinsichtlich erhöhten Temperaturen empfindliche Halbleiterbauteile als Teil von in dem Leitungsinstallationsgehäuse vorgesehenen Einrichtungen, z. B. Verstärker, Signalverarbeitungsschaltungen, elektrisch betriebene (und durch elektrische Signale angesteuerte) Signalumsetzer zur Erzeugung optischer Signale, optoelektronische Sensoren zum Empfang optischer Signale und Umsetzung in elektrische etc. Solche Bauteile können beschädigt werden, wenn z. B. durch direkte Sonneneinstrahlung und entsprechende Aufheizung im Innenraum des Leitungskonstruktionsgehäuses zu hohe Temperaturen entstehen.

Hinzu kommt die bei aktiven Bauteilen möglicherweise in erheblichem Umfang anfallende Abwärme, die zusätzlich zur Sonneneinstrahlung oder zu hohen Au-ßentemperaturen oder auch unabhängig davon zu Problemen führen kann.

Solche Probleme kollidieren mit dem grundsätzlichen Bedarf, den Innenraum gegenüber Verschmutzungen zu schützen (und damit nicht einfach mehr oder weniger offen zu gestalten, insbesondere nach oben).

Dementsprechend sieht die Erfindung einen Lüfter zur Kühlung des Innenraums vor, wobei dieser Lüfter an einen Zwischenraum der Gehäusewände angeschlossen ist. Dieser Zwischenraum entspricht dem Zwischenraum zwischen Innen- und Außenwand an zumindest einem doppelt ausgeführten Teil der Gehäusewände. Durch Anschluss an den Lüfter wird ein solcher Zwischenraum von einer erzwungenen Luftströmung durchsetzt und damit jedenfalls in typischen Problemsituationen gekühlt. So kann der Zwischenraum bei Sonneneinstrahlung auf die Außenwand durch die Luftströmung gekühlt werden oder auch bei erheblichem Wärmeanfall im Innenraum und dementsprechender Aufheizung der Innenwand. Vorzugsweise ist der Lüfter mit seiner Ansaug- oder mit seiner Ausstoßseite ausschließlich an einen solchen Zwischenraum oder mehrere solche Zwischenräume Grundsätzlich könnte der Lüfter natürlich die Luft in dem Zwischenraum umwälzen und/oder mit Luft in einem anderen Bereich des Leitungsinstallationsgehäuses, etwa einem weiteren Zwischenraum (z. B. auf der sonnenabgewandten Seite) austauschen. Die Belüftung erfolgt jedoch gegen die Umgebung außerhalb des Leitungsinstallationsgehäuses. Dazu kann z. B. die Außenwand Belüftungsöffnungen aufweisen, durch die der Zwischenraum in einem gewissen Umfang mit der Umgebung Luft austauschen kann. Der Lüfter kann somit mit seiner Ausstoßseite Umgebungsluft in den Zwischenraum hineinblasen, die dort teilweise oder ganz durch die Belüftungsöffnungen nach außen abgegeben wird, oder umgekehrt mit seiner Ansaugseite aus dem Zwischenraum Luft ansaugen und in die Umgebung abgeben, wobei der Zwischenraum durch die Belüftungsöffnungen Umgebungsluft nachzieht.

Dabei ist der Lüfter (auf den fertig installierten Betriebszustand des Leitungsinstallationsgehäuses bezogen) vorzugsweise über dem Innenraum oder dem Zwischenraum angeordnet, also im oberen Bereich des Leitungsinstallationsgehäuses. In diesem Bereich stört die Unterbringung eines zusätzlichen Bauteils besonders wenig, weil hierdurch weder die Bautiefe noch die Breite verändert werden müssen. Wenn der Lüfter mit seiner Ansaugseite an den Zwischenraum angeschlossen ist, kann er von einer in dem Zwischenraum in gewissem Umfang möglicherweise ohnehin auftretenden Konvektionsströmung unterstützt werden und muss nicht gegen diese arbeiten. Vorzugsweise ist der Lüfter dabei durch eine Wand von dem Innenraum getrennt und vorzugsweise in einem eigenen Gehäuse (gegebenenfalls mit weiteren Bauteilen, worauf noch eingegangen wird) angeordnet. Wiederum vorzugsweise ist der Lüfter eher am Rand des oberen Bereichs des Leitungsinstallationsgehäuses angeordnet und kann damit, wenn es sich um den dem Zwischenraum zugeordneten Rand handelt, leicht mit dem Zwischenraum verbunden sein. Die Anordnung am Rand ist auch vorteilhaft für die Kombination mit einem Kondensationslüfter, auf die noch näher eingegangen wird.

Der Zwischenraum hat vorzugsweise ein Hochformat, was insbesondere in Kombination mit der obigen Anordnung des Lüfters und einer Unterstützung durch Konvektion von Vorteil ist und ansonsten auch gut zu typischen Dimensionen von Leitungsinstallationsgehäusen passt. Er ist also mindestens höher als breit (aus der Perspektive mit Blickrichtung auf eine zu öffnende Tür des Gehäuses) und vorzugsweise auch höher als tief, wobei diese Aussage bei einer Mehrzahl Zwischenräume nicht für alle gelten muss.

Ferner kann die Innenwand aus Metallblech aufgebaut sein und damit, auch ohne Belüftungslöcher und mit einer zugunsten des Verschmutzungsschutzes weitgehend dichten Struktur, trotzdem effektiv Wärme von innen nach außen weitergeben. Natürlich kann die Blechwand dabei auch zusätzliche Verstärkungsstrukturen aus anderem Material oder aus nicht als Blech zu bezeichnenden Metallelementen aufweisen. Das Gehäuse kann auch im Übrigen aus Blech bestehen. Aber auch Kunststoffgehäuse z. B. aus Polycarbonat können vorteilhaft sein.

Der Erfindung sieht ein aktives Kühlaggregat zur Kühlung des Gehäusesinnenraums vor, wobei "aktiv" den Einsatz eines Kältemittelkreislaufs mit Kompressor, Verdampfer und Kondensator meint. Mit einem solchen Kühlaggregat können thermisch besonders anspruchsvolle Aufgaben beherrscht werden. Dabei ist für den Verdampfer ein Verdampferlüfter vorgesehen und weiterhin auch ein Kondensatorlüfter für den Kondensator, wobei diese Lüfter jeweils zum Luftaustausch um die entsprechenden Kältemittelwärmetauscher herum vorgesehen sind, also z. B. zum Erzeugen einer Luftströmung an Leitungsschlangen vorbei. Zumindest einer dieser beiden Lüfter kann dann der bereits beschriebene Lüfter für den Anschluss an den Zwischenraum sein, insbesondere der Kondensatorlüfter. Zum Beispiel kann der Kondensatorlüfter aus dem Zwischenraum Luft ansaugen und damit den Kondensator anblasen, um die dort anfallende Wärme abzutransportieren (insbesondere in die Außenumgebung).

Ein weiterer Lüfter, insbesondere ein weiterer der beiden Kühlaggregatlüfter und insbesondere der Verdampferlüfter, kann an den Innenraum angeschlossen sein. Vorzugsweise erfolgt dies mit der Ansaugseite und der Ausstoßseite dieses Lüfters, sodass in dem Innenraum eine Temperaturschichtung verwirbelt wird. Dies ist insoweit vorteilhaft, als durch Einführung von Außenluft in den Innenraum zusätzliche Verschmutzungsrisiken bestehen, und zwar zum einen wegen der nötigen Öffnungen an sich und zum zweiten zusätzlich durch den erzwungenen Lufttransport dort hindurch. Stattdessen kann bei einer Umluftlösung im Innenraum dieser weitgehend von der Außenumgebung abgetrennt werden. Trotzdem kann einer Schichtung entgegengewirkt werden und durch die Luftströmung außerdem der Wärmeübergang an die Außenwände und damit auch an den Zwischenraum (oder, wo keine Doppelwände existieren, an die Umgebung) gefördert werden. Wenn es sich um den Verdampferlüfter handelt, kann dieser natürlich die im Innenraum anfallende Wärme an den Verdampfer weitergeben und damit die aktive Kühlung unterstützen.

Aber auch wenn der Kompressor gar nicht in Betrieb ist, können die beiden Lüfter, und zwar im Prinzip jeder für sich und natürlich insbesondere beide in Kombination, zur Kühlung des Innenraums beitragen. Dies betrifft insbesondere Situationen mit Kühlbedarf, in denen ein Betrieb des Kompressors noch vermieden werden soll oder kann. So kann durch Betrieb zumindest eines der beiden Lüfter, insbesondere des an den Zwischenraum angeschlossen Lüfters, trotz Vermeidung der aktiven Kühlung im Sinn des Kompressorbetriebs durch die beschriebenen Luftströmungen eine deutliche thermische Verbesserung erreicht werden. Damit können Temperatur-Einschaltschwellen für das Kühlaggregat erhöht werden und können Geräuschniveau und Energieverbrauch weiter gesenkt werden.

Zum Beispiel kann man sich vorstellen, dass in den Morgenstunden zunächst nur einer oder beide beschriebenen Lüfter laufen und dann, bei zunehmender Sonneneinstrahlung und/oder Umgebungstemperatur, irgendwann der Kältemittelkreislauf mit dem Kompressor zusätzlich eingeschaltet wird. Umgekehrt vielleicht am Abend oder späteren Nachmittag. Bei höherem Kühlbedarf könnte z. B. der reine Lüfterbetrieb in den Nachtstunden genügen und der Kompressor nur tagsüber benutzt werden oder nur an warmen oder sonnigen Tagen etc.

Ein besonders bevorzugtes Anwendungsgebiet sind Leitungsinstallationen mit Wandlern zur elektrisch/optischen Signalwandlung, also zur Übertragung von Signalen zwischen elektrischen Signalleitungen einerseits und optischen andererseits. Dies können z. B. Übergänge von Glasfaserleitungen auf lokale Kupferleitungssysteme sein.

Schließlich richtet sich die Erfindung auch auf die Verwendungskategorie und die vorstehende und die nachfolgende Beschreibung sind dementsprechend auch im Hinblick auf diese Kategorie zu verstehen.

Die erfindungsgemäße Kühlproblematik tritt vor allem auch bei Leitungsinstallationsgehäusen im Außenbereich auf, vor allem in sonnenbeschienenen Situationen und in der warmen Jahreszeit, weswegen für den Außenbereich-Einsatz ausgelegte Leitungsinstallationsgehäuse bzw. eine entsprechende Verwendung bevorzugt sind.

Im Folgenden wird die Erfindung anhand eines Ausführungsbeispiels näher erläutert.

Im Einzelnen zeigt
- Figur 1: eine perspektivische Ansicht eines erfindungsgemäßen Leitungsinstallationsgehäuses mit geöffneten Vordertüren und mit einem im oberen Bereich montierten Kühlaggregat;
- Figur 2: im unteren Bereich eine Draufsicht auf das Leitungsinstallationsgehäuse aus Figur 1, jedoch nach Demontage des Kühlaggregats und ohne den Innenaufbau aus Figur 1, im oberen Bereich eine Seitenansicht dazu in verkleinertem Maßstab;
- Figur 3: eine Vorderansicht des Leitungsinstallationsgehäuses aus Figur 1, erneut ohne Innenaufbau;
- Figur 4: eine perspektivische Ansicht des in Figur 1 und Figur 3 jeweils oben sichtbaren Kühlaggregats unter Weglassung des Gehäuses;
- Figur 5: eine perspektivische Ansicht eines Teils des vorderen Gehäuseteils aus den Figuren 1 bis 3 mit akustischen Platten.

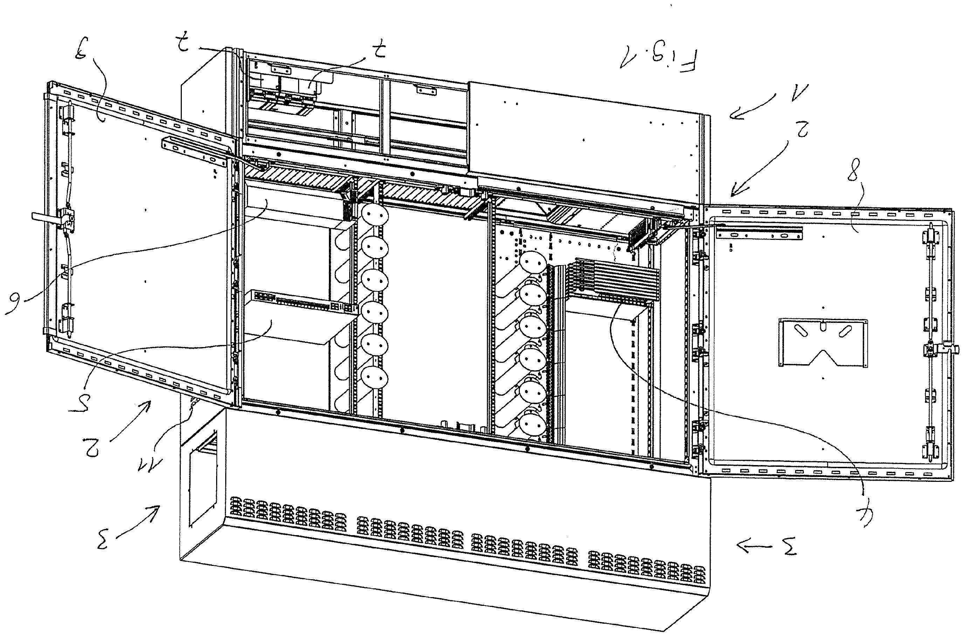

In Figur 1 erkennt man ein erfindungsgemäßes Leitungsinstallationsgehäuse für Glasfaserkabel-Installationen. Dieses Gehäuse weist einen unteren Teil 1, einen mittleren Teil 2 und ein oberen Teil 3 auf. Der untere Teil 1 dient zum Einführen von z. B. aus dem Boden unter dem Leitungsinstallationsgehäuse aufsteigenden Glasfaserkabelbündeln, die dann, in einzelne Stränge aufgeteilt, in an sich bekannter Form durch im Wesentlichen horizontal verlaufende Zwischenelemente zwischen dem unteren Teil 1 und dem mittleren Teil 2 hindurchtreten. Im mittleren Teil 2 ist links eine Moduleinheit 4 mit einer Mehrzahl übereinander gestapelter Spleiß- und Patchmodule dargestellt. Im rechten Bereich ist eine aktive elektronische Baugruppe dargestellt, weiter unten eine Notstromversorgung 6, deren Batterie 7 im unteren Teil rechts dargestellt ist. Alle diese Elemente sind exemplarisch und, was die Elemente 4 und 5 betrifft, in relativ kleiner Zahl dargestellt. Weitere Elemente dienen dem sogenannten Kabelmanagement, also der geordneten geometrischen Führung einer Vielzahl von hier nicht eingezeichneten Glasfaserkabeln und sind an sich bekannt.

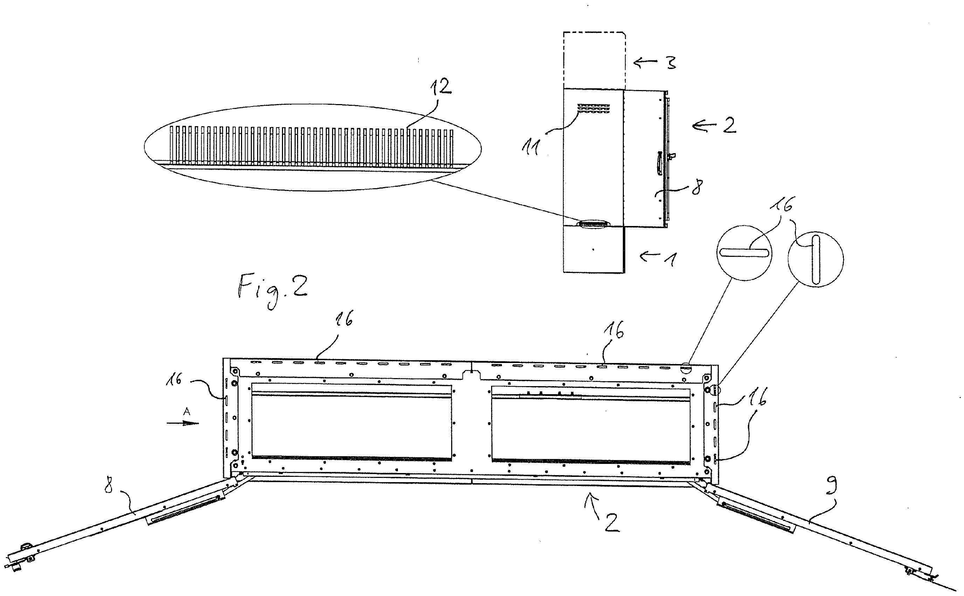

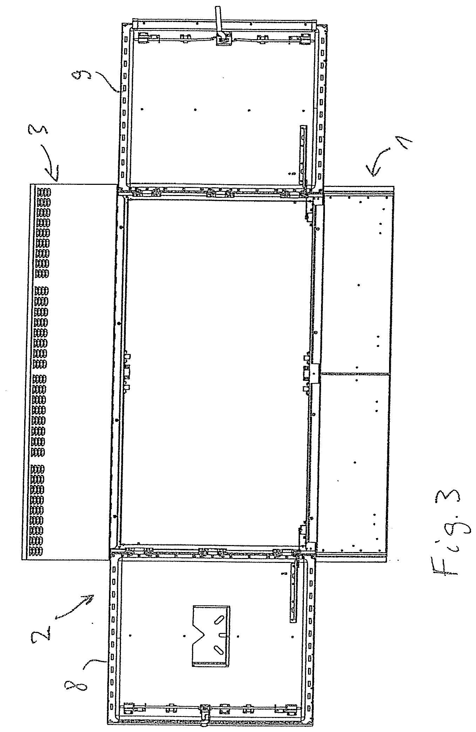

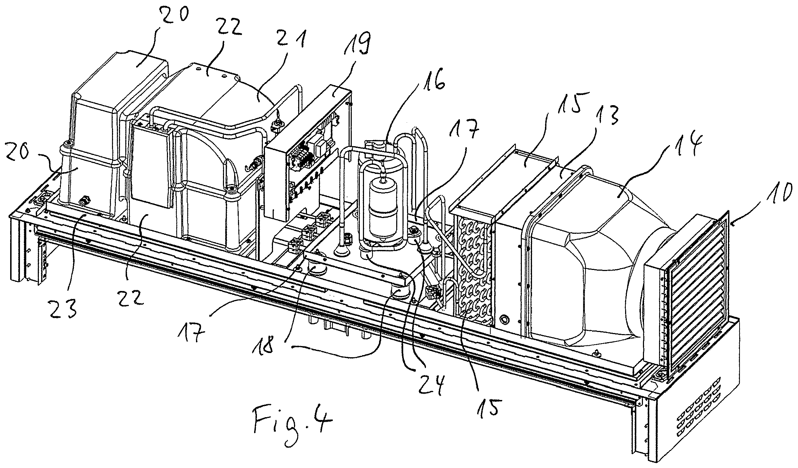

Der mittlere Teil ist nach vorn durch zwei in den Figuren offenstehende Türen 8 und 9 verschließbar. Er endet im oberen Bereich in einer anhand Figur 2 noch näher zu erläuternden horizontalen Abtrennung, über der der obere Teil 3 mit einem Kühlaggregat dargestellt ist. Dieses Kühlaggregat ist in einem Gehäuse mit Blechwänden untergebracht und, was den inneren technischen Teil betrifft, in Figur 4 näher dargestellt. Das Blechgehäuse weist an seiner rechten Stirnseite in dem quadratischen Ausschnitt in Figur 1 und 3 einen in Figur 4 rechts dargestellten Einsatz 10 mit durch Lamellen getrennten Schlitzöffnungen zum Abführen von Abluft bzw. Abwärme und im Übrigen in Figur 1 und 3 nach vorn weisend kleine Lüftungsöffnungen auf.

Ähnliche Belüftungsöffnungen finden sich mit dem Bezugszeichen 11 in der rechten Seitenwand des mittleren Teils 2 in Figur 1 und, auf der entgegengesetzten Seite, in der Seitenansicht in Figur 2 oben. Diese dienen zur Belüftung eines jeweiligen seitlichen Zwischenraums, denn die beiden entsprechenden Seitenwände des mittleren Teils 2 des Leitungsinstallationsgehäuses sind doppelwandig. Das gilt auch, wenngleich nicht in den Zeichnungen zu erkennen, für die in den Figu-ren 1 und 3 nach hinten weisende Rückseite. Weitere Belüftungsöffnungen 12 findet man im unteren Bereich der beiden Seitenwände und der Rückwand, vergleiche Figur 2 oben einschließlich der vergrößerten Darstellung oben links.

Im Prinzip könnte man die Zwischenräume also durch eine passive Konvektionsströmung kühlen, weil die beschriebenen Belüftungsöffnungen 11 und 12 auf sehr unterschiedlichen Höhen angeordnet sind. Erfindungsgemäß ist jedoch zusätzlich eine Zwangsströmung durch diese Zwischenräume vorgesehen, und zwar unter Verwendung eines Kondensatorlüfters 13 des in Figur 4 näher dargestellten Kühlaggregats.

In Figur 4 erkennt man den gerade erwähnten Kondensatorlüfter 13 des Kühlaggregat rechts. Er ist über ein trichterartiges Luftführungsgehäuse 14 angeschlossen an den bereits erwähnten Einsatz 10 zum Abführen der warmen Abluft. Links von dem Kondensatorlüfter 13 erkennt man die diesem zugeordneten Wärmetauscherschlangen des Kältemittelkreislaufs, wobei diese Einheit mit 15 bezeichnet ist. Der Kondensatorlüfter 13 zieht als Axiallüfter Luft aus dieser Einheit 15 an (und führt sie über das Luftführungsgehäuse 14 und den Einsatz 10 nach außen), wobei diese Luft aus dem Innenvolumen des Gehäuses des gesamten Kühlaggregats angesaugt wird. In dieses Innenvolumen wird sie nachgeführt durch an den Oberseiten der jeweiligen Zwischenräume der Seitenwände und der Hinterwand angebrachte schlitzartige Öffnungen 16, vergleiche Figur 2, sodass in den Zwischenräumen eine Zwangsströmung entsteht und durch die bereits zuvor erwähnten Belüftungsöffnungen 11 Außenluft nachgeführt wird.

Außerdem zeigen die Figuren 1 und 3 vorderseitige Belüftungsschlitze an dem Kühlaggregat-Gehäuse, durch welche Lüftungsschlitze ebenfalls Luft nachgeführt wird. Dies beeinträchtigt den Kühleffekt der bereits erläuterten erzwungenen Konvektionsströmung nicht wesentlich. Allerdings ist durch diese Belüftungsschlitze des Kühlaggregat-Gehäuses der Gesamtquerschnitt der Zuluft für den Kondensatorlüfter 13 vergrößert, was ihm im Vollbetrieb des Kompressors 16 und des Kältemittelkreislaufs zugutekommt. In diesem Vollbetrieb wäre die Belüftung allein über die Zwischenräume der doppelten Seitenwände etwas knapp. Natürlich könnte man die Größe und Zahl der Öffnungen zwischen diesen Zwischenräumen und dem Kühlaggregat-Gehäuse vergrößern, um ein ähnliches Ergebnis zu erzielen.

Die Platte 17 hat zwar, wie Figur 4 andeutet, eine Wannenform (ähnlich wie die Grundplatte des gesamten Kühlaggregats) zum Auffangen von etwaigem Kondensat; es handelt sich aber zusätzlich um eine bewusst massereich ausgeführte Stahlplatte von ungefähr 2.000 g. Dieses Gewicht wird abhängig von der Masse des Kompressors und den mechanischen Eigenschaften der Elastomerfüße 18 und 14 empirisch ermittelt und spielt bei der Körperschallunterdrückung eine Rolle.

Links von dem Kondensatorblock aus den Elementen 13, 14 und 15 ist ein Kältekompressor 16 eingezeichnet, der auf einer separaten Montageplatte 17 mit schwingungsabsorbierenden Elastomerfüßen 18 steht. Dabei ist die Montageplatte 17 ungefähr quadratisch mit vier Elastomerfüßen 18 montiert, wobei der Kompressor 16 selbst auf in diesem Fall drei weiteren (kleineren) schwingungsabsorbierenden Elastomerfüßen 24 steht und über diese an die Montageplatte 17 gekoppelt ist. Bei einer anderen bevorzugten Ausgestaltung kann auch diese Verbindung mit vier Elastomerfüßen 24 ausgeführt sein, dann also mit einer eher quadratischen statt dreieckigen Geometrie.

Noch weiter links erkennt man eine elektronische Mikro-Controller-Steuerung 19 und links davon einen Verdampferblock, dessen linker Teil ein radial wirkender Verdampferlüfter 20 ist. Dieser ist unterseitig durch eine Öffnung an das Innenvolumen des Leitungsinstallationsgehäuses angeschlossen (nicht an den Zwischenraum der linken Seitenwand). Rechts von dem Verdampferlüfter gibt es einen Luftführungskasten 21, der über eine weitere unterseitige Öffnung an den Innenraum des Leitungsinstallationsgehäuses angeschlossen ist. Dazwischen liegt ein Block Wärmetauscherschlangen 22 des Kältmittelkreislaufs. Damit kann der Verdampferlüfter 20 einerseits (z. B. von unten) Innenraumluft ansaugen und andererseits (z. B. über den Luftführungskasten 21) Luft wieder in den Innenraum zurückführen. Bereits ohne Betrieb des Kältemittelkreislaufs bzw. des Kompressors 16 kann der Verdampferlüfter 20 damit in einer bereits beschriebenen Weise die Innenraumluft umwälzen und durchmischen.

Bei den beiden Lüftern handelt es sich um EC-Lüfter mit steuerbarer Drehzahl. Damit können die Lüfter im Betrieb des Kältemittelkreislaufs und auch außerhalb dessen mit unterschiedlicher Leistung und damit nur der unvermeidlichen Geräuschemission betrieben werden.

Die gesamte erläuterterte Technik ist (zusätzlich zu der schwingungabsorbierenden Lagerung der Platte 17 und des Kompressors 16) auf einer eigenständigen Montageplatte 23 aufgebaut, die ihrerseits über weitere schwingungsabsorbierende Elastomerfüße auf der in Figur 2 sichtbaren Oberseite des mittleren Teils 2 des Leitungsinstallationsgehäuses aufgesetzt ist.

Figur 4 zeigt im Bereich des Luftführungskastens 21 und des Wärmetauscherschlangenblocks 22 sowie um den Kompressor 16 herum und von dort aus zu dem Wärmetauscherschlangenblock 15 verschiedene weitere weitgehend frei verlaufende Leitungsabschnitte von Rohrleitungen des Kältemittelkreislaufs. Diese Leitungen sind an manchen Stellen, etwa in Figur 4 links von der Platte 17 und auch rechts davon sowie im Durchgang durch die Platte 17, in einer schwingungsabsorbierenden Weise unter Zwischenschaltung von Elastomerteilen gestützt. Im Übrigen sind sie aber gezielt an bestimmten Stellen durch Gewichte beschwert, was Figur 4 nicht im Einzelnen darstellt. Damit können Resonanzfrequenzen beeinflusst und insbesondere verringert werden und kann das Gesamtschwingungsverhalten des Leitungssystems verbessert werden.

Ohne wesentlichen Kühlbedarf bleiben die einzelnen Elemente des Kühlaggregats außer Funktion und wird das Leitungsinstalltionsgehäuse, insbesondere sein mittlerer Teil 2, in an sich konventioneller Weise durch Abstrahlung und durch eine passive Konvektion der Luft in den Zwischenräumen der Doppelwände gekühlt. Bei steigendem Kühlbedarf kann der Kältemittelkreislauf, insbesondere der Kompressor 16, zunächst außer Betrieb bleiben und damit eine erhebliche Einsparung an Geräuschemission und Energieverbrauch erzielt werden, indem zunächst zumindest einer der beiden beschriebenen Lüfter 13 und 20 benutzt wird. Der Kondensatorlüfter 13 führt dabei zu einer verstärkten Zwangsluftströmung durch die Zwischenräume und der Verdampferlüfter 20 durchmischt die Innenraumluft und verteilt damit die anfallende Abwärme gleichmäßiger. Damit werden insbesondere lokale Temperaturspitzen an kritischen Stellen, insbesondere bei Leistungsbauteilen, vermieden. Je nach Einzelfall kann natürlich zunächst nur einer der beiden Lüfter 13 und 20 benutzt werden, wobei natürlich auch die Drehzahl der Lüfter 13 und 20 angepasst werden kann, und zwar zusätzlich oder alternativ.

Bei weiter steigendem Kühlbedarf werden der Kompressor 16 und damit der Kältemittelkreislauf eingeschaltet. Die beschriebenen Wirkungen bleiben erhalten, jedoch ist die von dem Verdampferlüfter in den Innenraum zurückgeführte Luft dann aktiv gekühlt. Der Kältemittelkreislauf transportiert die Abwärme zu dem Wärmetauscher 15 des Kondensatorlüfters, sodass die dort dann anfallende Abwärme über den Kondensatorlüfter 13, das Luftführungsgehäuse 14 und den Einsatz 10 nach außen abgeführt wird. Sowohl die Durchmischung durch den Verdampferlüfter 20 als auch die saugende Konvektionsunterstützung in den Zwischenräumen sind besonders effektiv, weil beide Lüfter mit dem Kühlaggregat über dem zu kühlenden Innenraum angeordnet sind.

Der Kühlbedarf entsteht typischerweise nicht durch in dem Leitungsinstallationsgehäuse verbaute Glasfaserinstallationen und zugeordnete passive Komponenten, sondern durch aktive optoelektronische Komponenten und elektronische Schaltungen, wie sie in der beispielhaft eingezeichneten Baugruppe 5 vorhanden sind. Die elektronischen Komponenten sind typischerweise auch die temperaturempfindlichsten Bauteile. Insoweit ist die Anordnung der Komponenten in Figur 4 in Anbetracht der Anordnung der Baugruppe 5 in Figur 1 rechts nicht ganz optimal (und gehört gewissermaßen zu einem rechts/links-vertauschten Beispiel). Sinnvollerweise werden die temperaturerzeugenden und die temperaturempfindlichsten Bauteile und -gruppen möglichst unter dem Verdampferlüfter 20 angeordnet, weil dieser im aktiven Kühlbetrieb nicht nur Warmluft abführt und aktiv gekühlte Kaltluft nach unten befördert, sondern andererseits auch im reinen Lüfterbetrieb am wirksamsten einer Temperaturspitze durch einen Wärmestau entgegenwirkt.

Für einen möglichen Stromausfall sollen solche Leitungsinstallationen einschließlich der optoelektronischen und elektronischen Komponenten wie in dem Element 5 zumindest in einem Notbetrieb weiterlaufen. Daher ist eine Notstromversorgung 6 mit einer Batterie 7 vorgesehen, die erfindungsgemäß so ausgelegt ist, dass damit zumindest einer der beiden beschriebenen Lüfter 13, 20 des Kühlaggregats, vorzugsweise beide, weiter betrieben werden kann. So kann für diesen Notbetrieb eine verbesserte Basiskühlfunktion bereitgestellt werden, die in aller Regel ausreichen dürfte, weil der Notbetrieb typischerweise einen verkleinerten Wärmeanfall mit sich bringt.

Im Übrigen kann der Betrieb der Lüfter und des gesamten Kühlaggregats durch entsprechende Temperatursensoren an charakteristischen Stellen temperaturgesteuert oder auch einfach (aufgrund empirischer Befunde) tageszeitgesteuert erfolgen. Bei einer typischen Aufstellung des Leitungsinstallationsgehäuses im Freien oder jedenfalls unter Sonneneinwirkung können die beschriebenen Komponenten nachts z. B. außer Betrieb bleiben, könnte nach Sonnenaufgang im Verlauf des Vormittags zunächst z. B. eine reine Lüfterfunktion aufgenommen werden und könnte dann z. B. gegen Mittag und bis z. B. zum späten Nachmittag die aktive Kühlung mit dem Kältemittelkreislauf und dem Kompressor 16 laufen. Dann könnte in den Abend hinein wieder auf einen reinen Lüfterbetrieb umgeschaltet und am späteren Abend auch dieser eingestellt werden.

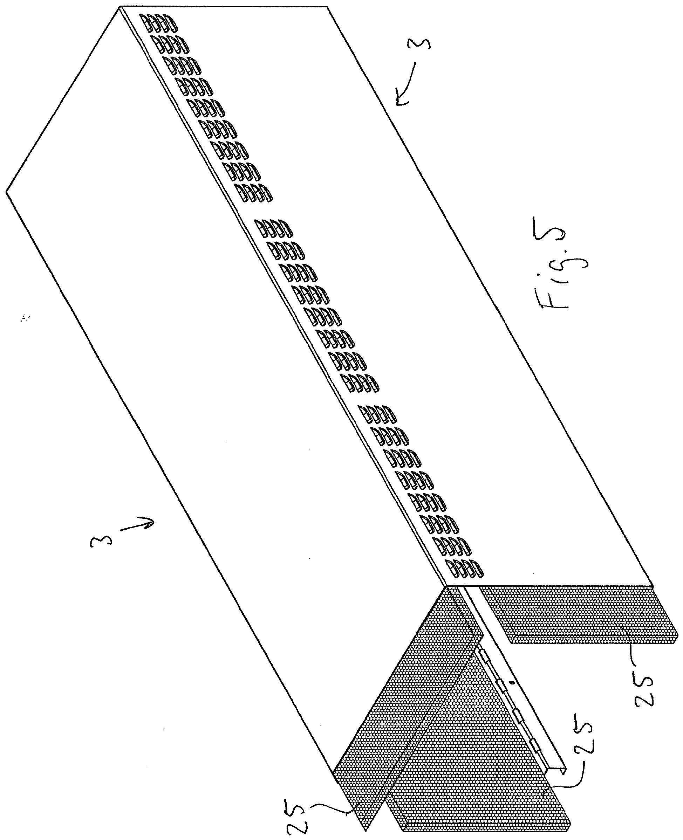

Figur 5 zeigt den oberen Gehäuseteil 3 aus den Figuren 1 bis 3 für sich und ohne Seitenteile (stirnseitig). Dabei sind zur Veranschaulichung am linken Ende innere akustische Plattenbeschichtungen 25 dargestellt (die tatsächlich natürlich nur innerhalb der Blechwände vorliegen). Es handelt sich dabei tatsächlich um Mehrschichtplatten 25, die einerseits relativ schwere Schichten außen (Schwerfolie) und andererseits nach weiter innen zunehmend leichtere Schichten mit außerdem dämmender Funktion sind. Solche Beschichtungen sind innerhalb des Gehäuseteils 3 mit Ausnahme der Bereiche mit den Belüftungsschlitzen (wie in Figur 5 dargestellt und außerdem an der rechten Seite der Figuren 1 bis 3) im wesentlichen vollständig vorgesehen, also oben, hinten, vorn und links. Auch damit lässt sich die Geräuschemission wirksam reduzieren.

## Patentansprüche

1. Leitungsinstallationsgehäuse (1, 2, 3) für Signalleitungen, mit Gehäusewänden,
einem durch die Gehäusewände abgeschlossenen Innenraum für die Signalleitungsinstallation,
wobei die Gehäusewände zumindest zum Teil eine Innenwand und eine weitere Außenwand des Leitungsinstallationsgehäuses aufweisen, die zwischen sich einen Zwischenraum abgrenzen,
einem Lüfter (13) zur Kühlung des Innenraums, wobei der Lüfter (13) an zumindest einen Zwischenraum der Gehäusewände angeschlossen ist, im Betrieb eine Luftströmung durch den Zwischenraum zur Kühlung des Innenraums erzwingt und wobei der Zwischenraum gegen eine Umgebung außerhalb des Leitungsinstallationsgehäuses belüftet ist, und **gekennzeichnet durch** ein Kühlaggregat (13-23) zur aktiven Kühlung des Innenraums, welches Kühlaggregat (13-23) einen Kältemittelkreislauf mit einem Kompressor (16) für das Kältemittel, einem Verdampfer (22) und einen Kondensator (15) aufweist sowie ferner einen Verdampferlüfter (20) und einen Kondensatorlüfter (13),
wobei zumindest einer aus der Gruppe aus dem Kondensatorlüfter (13) und dem Verdampferlüfter (20) der an den Zwischenraum angeschlossene Lüfter (13) ist.

2. Leitungsinstallationsgehäuse (1, 2, 3) nach Anspruch 1, bei dem die zumindest eine Außenwand Belüftungsöffnungen (11, 12) für den Zwischenraum aufweist und die zumindest eine Innenwand nicht.

3. Leitungsinstallationsgehäuse (1, 2, 3) nach Anspruch 1 oder 2, bei dem der Lüfter (13) über dem Innenraum oder Zwischenraum angeordnet ist und mit seiner Ansaugseite mit dem zumindest einen Zwischenraum verbunden ist.

4. Leitungsinstallationsgehäuse (1, 2, 3) nach einem der vorstehenden Ansprüche, bei dem der zumindest eine Zwischenraum ein Hochformat hat.

5. Leitungsinstallationsgehäuse (1, 2, 3) nach einem der vorstehenden Ansprüche, bei dem die zumindest eine Innenwand aus Metallblech besteht.

6. Leitungsinstallationsgehäuse (1, 2, 3) nach einem der vorstehenden Ansprüche, bei dem der an den Zwischenraum angeschlossene Lüfter der Kondensatorlüfter (13) ist.

7. Leitungsinstallationsgehäuse (1, 2, 3) nach einem der vorstehenden Ansprüche, bei dem ein weiterer Lüfter, insbesondere der Verdampferlüfter (20), mit seiner Ansaugseite und seiner Ausstoßseite an den Innenraum angeschlossen ist und zur Verwirbelung einer Temperaturschichtung darin ausgelegt ist.

8. Leitungsinstallationsgehäuse (1, 2, 3) nach einem der vorstehenden Ansprüche, dazu ausgelegt, dass der Kondensatorlüfter (13) des Kühlaggregats (13-23) an den Zwischenraum angeschlossen ist und in Situationen mit Kühlbedarf bei ausgeschaltetem Kompressor (16) des Kühlaggregats (13-23) betrieben wird und in Situationen mit höherem Kühlbedarf das Kühlaggregat (13-23) einschließlich des Kompressors (16) betrieben wird.

9. Leitungsinstallationsgehäuse (1, 2, 3) nach einem der vorstehenden Ansprüche mit einer Notstromversorgung (6, 7) für die Leitungsinstallation, vorzugsweise mit einer Batterie (7), dazu ausgelegt, dass im Notbetrieb und bei Kühlbedarf zumindest ein Teil des Kühlaggregats (13-23) betrieben und von der Notstromversorgung (6,7) versorgt wird.

10. Leitungsinstallationsgehäuse (1, 2, 3) nach Anspruch 9, dazu ausgelegt, dass in dem Notbetrieb und bei Kühlbedarf der zumindest eine aus der Gruppe aus dem Kondensatorlüfter (13) und dem Verdampferlüfter (20) zur Kühlung betrieben wird, der Kompressor (16) des Kühlaggregats (13-23) aber nicht.

11. Leitungsinstallationsgehäuse (1, 2, 3) nach einem der vorstehenden Ansprüche, bei dem eine Leitungsinstallation des Leitungsinstallationsgehäuses Wandler (5) zur Signalübertragung zwischen elektrischen und optischen Signalleitungen oder umgekehrt aufweist, insbesondere für Telekommunikationsleitungen.

12. Verwendung eines Leitungsinstallationsgehäuses (1, 2, 3) nach einem der vorstehenden Ansprüche, bei welcher Verwendung der an den Zwischenraum angeschlossene Lüfter (13) die Luftströmung durch den Zwischenraum zur Kühlung des Innenraums erzwingt.

13. Verwendung nach Anspruch 11, bei welcher Verwendung das Leitungsinstallationsgehäuse (1, 2, 3) außerhalb eines Gebäudes im Freien eingesetzt wird.

## Claims

1. Cable installation housing (1, 2, 3) for signalling cables, with housing walls,
an interior space for the signalling cable installation closed off by the housing walls,
wherein the housing walls have at least in part an inner wall and a further outer wall of the cable installation housing, which define an intermediate space between them,
a fan (13) for cooling the interior, wherein the fan (13) is connected to at least one intermediate space of the housing walls, during operation forces an air flow through the intermediate space for cooling the interior and wherein the intermediate space is ventilated against an environment outside the cable installation housing,
and **characterised by**
a cooling unit (13-23) for active cooling of the interior, which cooling unit (13-23) has a refrigerant circuit with a compressor (16) for the refrigerant, an evaporator (22) and a condenser (15) and further has an evaporator fan (20) and a condenser fan (13),
wherein at least one of the group consisting of the condenser fan (13) and the evaporator fan (20) is the fan (13) connected to the intermediate space.

2. Cable installation housing (1, 2, 3) according to claim 1, in which the at least one outer wall has ventilation openings (11, 12) for the intermediate space and the at least one inner wall does not.

3. Cable installation housing (1, 2, 3) according to claim 1 or 2, in which the fan (13) is arranged above the interior space or the intermediate space and is connected by its intake side to the at least one intermediate space.

4. Cable installation housing (1, 2, 3) according to any one of the preceding claims, wherein the at least one intermediate space has a vertical format.

5. Cable installation housing (1, 2, 3) according to one of the preceding claims, wherein the at least one inner wall is made of sheet metal.

6. Cable installation housing (1, 2, 3) according to one of the preceding claims, wherein the fan connected to the intermediate space is the condenser fan (13).

7. Cable installation housing (1, 2, 3) according to one of the preceding claims, in which a further fan, in particular the evaporator fan (20), is connected with its intake side and its discharge side to the interior space and is designed to swirl a temperature stratification therein.

8. Cable installation housing (1, 2, 3) according to one of the preceding claims, adapted to that the condenser fan (13) of the cooling unit (13-23) is connected to the intermediate space and is operated with the compressor (16) of the cooling unit (13-23) switched off in situations with a cooling requirement and the cooling unit (13-23) including the compressor (16) is operated in situations with a higher cooling requirement.

9. Cable installation housing (1, 2, 3) according to one of the preceding claims with an emergency power supply (6, 7) for the cable installation, preferably with a battery (7), adapted to that in emergency operation and when cooling is required at least a part of the cooling unit (13-23) is operated and supplied by the emergency power supply (6, 7).

10. Cable installation housing (1, 2, 3) according to claim 9, adapted to that in the emergency operation and when cooling is required, at least one of the group consisting of the condenser fan (13) and the evaporator fan (20) is operated for cooling, but the compressor (16) of the cooling unit (13-23) is not.

11. Cable installation housing (1, 2, 3) according to one of the preceding claims, in which a cable installation of the cable installation housing has converters (5) for signal transmission between electrical and optical signal cables or vice versa, in particular for telecommunication cables.

12. Use of a cable installation housing (1, 2, 3) according to one of the preceding claims, in which use the fan (13) connected to the intermediate space forces the air flow through the interspace to cool the interior space.

13. Use according to claim 11, in which use the cable installation housing (1, 2, 3) is used outside a building in the open air.

## Revendications

1. Enceinte d'installation de câbles (1, 2, 3) pour câbles de signaux, comportant :
des parois d'enceinte ;
un espace intérieur défini par les parois d'enceinte et destiné à l'installation des câbles de signaux,
lesdites parois d'enceinte présentant au moins partiellement une paroi intérieure et une autre paroi extérieure de l'enceinte d'installation de câbles, qui définissent un espace intermédiaire entre elles ;
un ventilateur (13) destiné à refroidir l'espace intérieur, le ventilateur (13) étant relié à au moins un espace intermédiaire des parois d'enceinte et forçant, à l'usage, un flux d'air à travers ledit espace intermédiaire afin de refroidir l'espace intérieur, et ledit espace intermédiaire étant ventilé vis-à-vis d'un environnement extérieur à l'enceinte d'installation de câbles, et
**caractérisé par** un groupe de refroidissement (13-23) destiné à refroidir activement l'espace intérieur, lequel groupe de refroidissement (13-23) présente un circuit de réfrigérant comportant un compresseur (16) pour le réfrigérant, un évaporateur (22) et un condenseur (15), et présente en outre un ventilateur (20) de l'évaporateur et un ventilateur (13) du condenseur,
au moins un ventilateur issu du groupe constitué du ventilateur (13) du condenseur et du ventilateur (20) de l'évaporateur représentant ledit ventilateur (13) relié audit espace intermédiaire.

2. Enceinte d'installation de câbles (1, 2, 3) selon la revendication 1, dans laquelle l'au moins une paroi extérieure présente des ouvertures de ventilation (11, 12) pour l'espace intermédiaire et l'au moins une paroi intérieure n'en présente pas.

3. Enceinte d'installation de câbles (1, 2, 3) selon la revendication 1 ou 2, dans laquelle le ventilateur (13) est agencé au-dessus de l'espace intérieur ou de l'espace intermédiaire et est raccordé à l'au moins un espace intermédiaire par son côté aspiration.

4. Enceinte d'installation de câbles (1, 2, 3) selon l'une des revendications précédentes, dans laquelle l'au moins un espace intermédiaire a un format orienté verticalement.

5. Enceinte d'installation de câbles (1, 2, 3) selon l'une des revendications précédentes, dans laquelle l'au moins une paroi intérieure est constituée de tôle métallique.

6. Enceinte d'installation de câbles (1, 2, 3) selon l'une des revendications précédentes, dans laquelle le ventilateur (13) relié à l'espace intermédiaire est le ventilateur (13) du condenseur.

7. Enceinte d'installation de câbles (1, 2, 3) selon l'une des revendications précédentes, dans laquelle un autre ventilateur, notamment le ventilateur (20) de l'évaporateur, est relié audit espace intérieur par son côté aspiration et son côté refoulement et est conçu pour un effet de turbulence sur une stratification thermique y existant.

8. Enceinte d'installation de câbles (1, 2, 3) selon l'une des revendications précédentes, conçue pour que le ventilateur (13) du condenseur du groupe de refroidissement (13-23) soit relié à l'espace intermédiaire et soit exploité dans des situations demandant un refroidissement tandis que le compresseur (16) du groupe de refroidissement (13-23) est éteint, et dans des situations demandant un plus fort refroidissement, c'est le groupe de refroidissement (13-23), y compris le compresseur (16), qui est exploité.

9. Enceinte d'installation de câbles (1, 2, 3) selon l'une des revendications précédentes, comportant une alimentation électrique de secours (6, 7) pour l'installation de câbles, de préférence dotée d'une batterie (7) et conçue de telle façon que, en fonctionnement de secours, en présence d'une demande de refroidissement, au moins une partie du groupe de refroidissement (13-23) est exploitée et alimentée par l'alimentation électrique de secours (6, 7).

10. Enceinte d'installation de câbles (1, 2, 3) selon la revendication 9, conçue de telle façon que, en fonctionnement d'urgence et en présence d'une demande de refroidissement, l'au moins un ventilateur issu du groupe constitué du ventilateur (13) du condenseur et du ventilateur (20) de l'évaporateur est exploité pour effectuer le refroidissement, mais pas le compresseur (16) du groupe de refroidissement (13-23).

11. Enceinte d'installation de câbles (1, 2, 3) selon l'une des revendications précédentes, dans laquelle une installation de câbles de l'enceinte d'installation de câbles comprend des convertisseurs (5) permettant une transmission de signaux entre des câbles de signaux électriques et optiques ou vice versa, en particulier pour des câbles de télécommunications.

12. Utilisation d'une enceinte d'installation de câbles (1, 2, 3) selon l'une des revendications précédentes, dans laquelle utilisation le ventilateur (13) relié à l'espace intermédiaire force le flux d'air à traverser l'espace intermédiaire pour refroidir l'espace intérieur.

13. Utilisation selon la revendication 11, dans laquelle utilisation l'enceinte d'installation de câbles (1, 2, 3) est employée à l'extérieur d'un bâtiment, à l'air libre.
